Europäisches Patentamt

European Patent Office

Office européen des brevets

(11) Publication number: **0 159 824 B1**

# EUROPEAN PATENT SPECIFICATION

(45) Date of publication of patent specification: **15.01.92**  (51) Int. Cl.⁵: **H01L  27/10,** H01L 29/94

(21) Application number: **85302109.5**

(22) Date of filing: **26.03.85**

(54) Semiconductor device with recessed capacitor.

(30) Priority: **30.03.84 JP 62728/84**

(43) Date of publication of application:
**30.10.85 Bulletin  85/44**

(45) Publication of the grant of the patent:
**15.01.92 Bulletin  92/03**

(84) Designated Contracting States:
**DE FR GB**

(56) References cited:
**EP-A- 0 085 988**
**GB-A- 2 098 397**

**PATENT ABSTRACTS OF JAPAN, vol. 7, no.
72 (E-166)[1217], 25th March 1983; & JP - A -
58 3261**

(73) Proprietor: **KABUSHIKI KAISHA TOSHIBA
72, Horikawa-cho Saiwai-ku
Kawasaki-shi Kanagawa-ken 210(JP)**

(72) Inventor: **Oowaki, Yukihito c/o Patent Division
Kabushiki Kaisha Toshiba 1-1 Shibaura
1-chome
Minato-ku Tokyo 105(JP)**
Inventor: **Horiguchi, Fumio c/o Patent Division
Kabushiki Kaisha Toshiba 1-1 Shibaura
1-chome
Minato-ku Tokyo 105(JP)**

(74) Representative: **Freed, Arthur Woolf et al
MARKS & CLERK 57-60 Lincoln's Inn Fields
London WC2A 3LS(GB)**

EP 0 159 824 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The present invention relates generally to semiconductor devices and, more particularly, to a dynamic random access memory having memory cells each of which comprises a MOS transistor and a MOS capacitor and a plurality of dummy cells used to sense the logic state of a selected memory cell.

In a dynamic RAM (random access memory), logical data is electrically stored in a matrix of memory cells, each of which includes a MOS (metal oxide semiconductor) transistor and a MOS capacitor for storing a charge. Such memory cells are typically associated with each of the memory's bit lines.

A number of "dummy cells" are also included in the dRAM device. Each of such kind of cells includes a dummy capacitor which is precharged to a reference voltage level. In the data read mode of the memory, to sense the logical state of an addressed memory cell, the charge on the memory's cell capacitor is dumped on a first bit line and the charge on the dummy cell's capacitor is dumped on a second bit line. The resultant difference in voltage on the two bit lines is used as an indication of whether the selected memory cell is in a logic "1" or "0" state.

The storage of data in the MOS capacitor is made in a manner that a charge is also stored in the MOS capacitor. The charge storage capacity of the MOS capacitor thus greatly influences the data storage performance. Increasing the charge storage capacity of the MOS capacitor reduces the degree of integration of the dRAM, although this can contribute to the improvement of the basic performance of the dRAM. This is so because an increase in the charge storage capacity is attained by an increase in the capacitor area, which causes the area exclusively occupied by one element to increase and hence reduces the number of elements that can be formed in a unit area. EP-A-85988 is typical of references describing techniques for maximising the size of a memory cell in a limited area, this document corresponds to the preamble of claim 1.

In order to increase the charge storage capacity of the MOS capacitor while restricting the exclusive area of the substrate occupied by the MOS capacitor, it is contemplated to enlarge the capacitor area by forming a recess in the substrate surface in a memory capacitor formation region. In a dRAM that is realized on the basis of the above concept, it is desired in order to provide for the utmost redundancy of the sense-amplifier operation to set the ratio between the stored charge Qm in a memory cell capacitor Cm and stored charge Qd in a dummy cell capacitor Cd to 2 : 1. The stored charge is generally expressed as

$$Q = C V,$$

and hence the above setting of the stored charge ratio can be attained either by:

(1) setting the ratio of the capacitance Cm of the MOS capacitor constituting the memory cell to the capacitance Cd of the MOS capacitor constituting the dummy cell to 2 : 1, or by

(2) setting the ratio of the write voltage Vm applied to the memory cell to the write voltage Vd applied to the dummy cell to 2 : 1.

Of the above two approaches, the second approach requires an additional circuit arrangement for stably generating and supplying the write voltage applied to the dummy cell, leading to an undesired increase of the chip area and production cost. The first approach is free from the above drawback, but it has a fabrication difficulty in that it is difficult to satisfactorily control errors in shape in the process of forming the recess noted above, such errors cause undesired fluctuations of the capacitance ratio. Assuming that the recess is rectangular and has a constant depth, doubling the total length of the sides of the recess to make the capacitance of the memory cell double the capacitance of the dummy cell, leads to different values between the memory and dummy cells of the error ΔL that occurs for each side of the recess in an etching process of forming the recess. With such a variation of errors, the normal control of the capacitance ratio deteriorates.

To solve this problem, it has been suggested to form two recesses in the memory cell capacitor while forming one recess in the dummy cell capacitor. More specifically, for each memory cell capacitor two recesses, with the total length of the sides being a first length, are formed in the substrate, while for each dummy cell capacitor one recess with the total length of the sides being a second length equal to one half the first length is formed. In this case, even if the planar shape of these recesses which determine the capacitances of the memory cell capacitor and dummy cell capacitor is changed due to errors in the etching process of forming the recesses, the ratio of the first to the second lengths of the resultant recesses is constant at 2 : 1. It is thus possible to control the ratio of the capacitance between the first and second recesses so that it coincides with a predetermined value.

However, with increasing dRAM integration density in the future the distance between the two capacitor recesses in the memory cell is reduced. Where the two capacitor recesses are close to each other, there arises a problem, in that depletion layers, that are formed around the recesses when a charge is stored, are contiguous to each other. If the depletion layers around the two recesses are contiguous to each other, the charge storage performance greatly deteriorates, resulting in a decrease of the cell capacitance. Further, it is difficult to precisely set the capacitance ratio of the memory cell to the dummy cell to 2 : 1. Attempts to accurately set the capacitance ratio can be found in GB patent publication no. 2098 397.

It is an object of the present invention to provide a new and improved semiconductor memory device, which permits satisfactory control of the capacitance ratio between the dummy cell and memory cell in an ordinary fabrication process as well as permitting improvement in the charge storage capacity without sacrificing the degree of integration.

According to the present invention there is provided a semiconductor memory device comprising a plurality of memory cells (10) formed on a semiconductive substrate (14), in which each memory cell comprises:

a memory cell transistor (Qm) and a memory cell capacitor (Cm), each capacitor (Cm) comprises recess means (16a, 16b) formed in said substrate and each capacitor (Cm) is charged so as to reflect the logic state of its memory cell (10);

depletion layer spread suppressing means (20) for suppressing the spread of depletion layers formed around said recesses means (16a, 16b) of said memory cell capacitor (Cm) when charge is stored therein, thereby improving the charge storage efficiency of said memory cell capacitor; and

a plurality of dummy cells (12) each having a dummy cell transistor (Qd) and a dummy cell capacitor (Cd) having recess means, said capacitor being adapted to be precharged to a selected voltage level,

characterised in that said recess means comprises two first recesses (16a, 16b) whereas said recess means of said dummy cell capacitor (Cd) has one further recess (18), said first and further recesses being substantially equal in size such that a capacitance ratio of 2:1 between said memory cell capacitor (Cm) and said dummy cell capacitor (Cd) is controlled with an improved accuracy.

The present invention is best understood by reference to the accompanying drawings, in which:

Fig. 1 is a fragmentary enlarged-scale pictorial diagram showing a dynamic random access memory (referred to as dRAM, hereinafter) cell region as a preferred embodiment of the invention;

Fig. 2 is a cross sectional view taken along line II-II in Fig. 1 showing a memory cell section;

Fig. 3 is a cross sectional view taken along line III-III in Fig. 1 showing the memory cell section;

Fig. 4 is a cross sectional view taken along line IV-IV in Fig. 1 showing a dummy cell section; and

Fig. 5 is a cross sectional view taken along line V-V in Fig. 1 showing the dummy cell section.

In a semiconductor dynamic random access memory or dRAM as one preferred embodiment of the invention, one memory cell includes a memory cell transistor and a memory cell capacitor which is charged to reflect the logic state of its memory cell, while one dummy cell includes a dummy cell transistor and a dummy cell capacitor which is adopted to be precharged to a selected voltage level. A plurality of bit lines and word lines are provided for accessing a selected or particular memory cell.

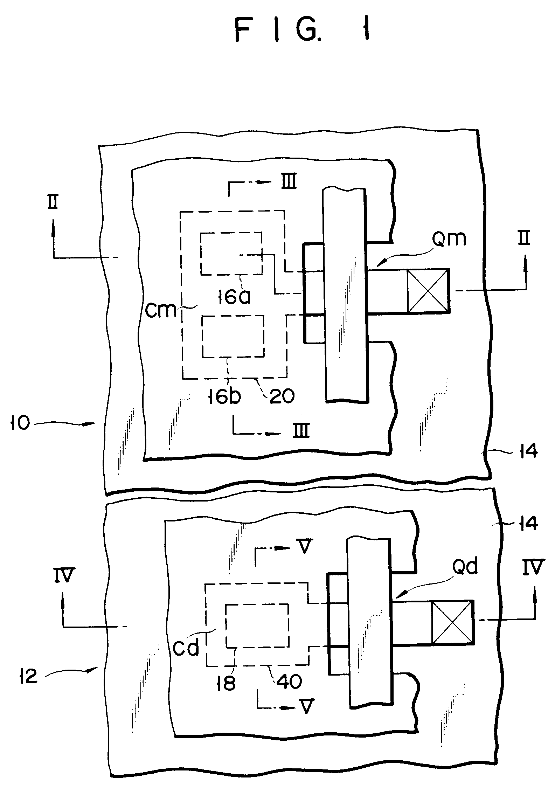

Referring to Fig. 1, there is shown, in a fragmentary enlarged-scale pictorial view, a memory cell region and a dummy cell region of a dRAM as one preferred embodiment of the invention. In the illustrated arrangement, memory cell section 10 and dummy cell section 12 are formed on a substrate 14 of a first conductivity type (e.g., p conductivity type). The memory cell 10 includes a MOS capacitor Cm and a MOS FET Qm. The dummy cell section 12 includes a MOS capacitor Cd and a MOS FET Qd.

The surface area of the substrate 14 where the MOS capacitor Cm of the memory cell 10 is formed has two recesses 16a and 16b of the same shape. The recesses 16a and 16b are rectangular in shape. In this embodiment, these recesses 16a and 16b are fabricated such that they have an equal constant depth. The surface area of the substrate 14 where the MOS capacitor Cd of the dummy cell 12 is formed, on the other hand, has a single recess 18. The recess 18 is also rectangular in shape, and it has the same depth as that of the recesses 16a and 16b. It should be noted that the total length of the four sides of the rectangle of each recess 16a or 16b of the memory cell capacitor Cm is equal to the total length of the sides of the rectangle of the recess 18 of the dummy cell capacitor Cd.

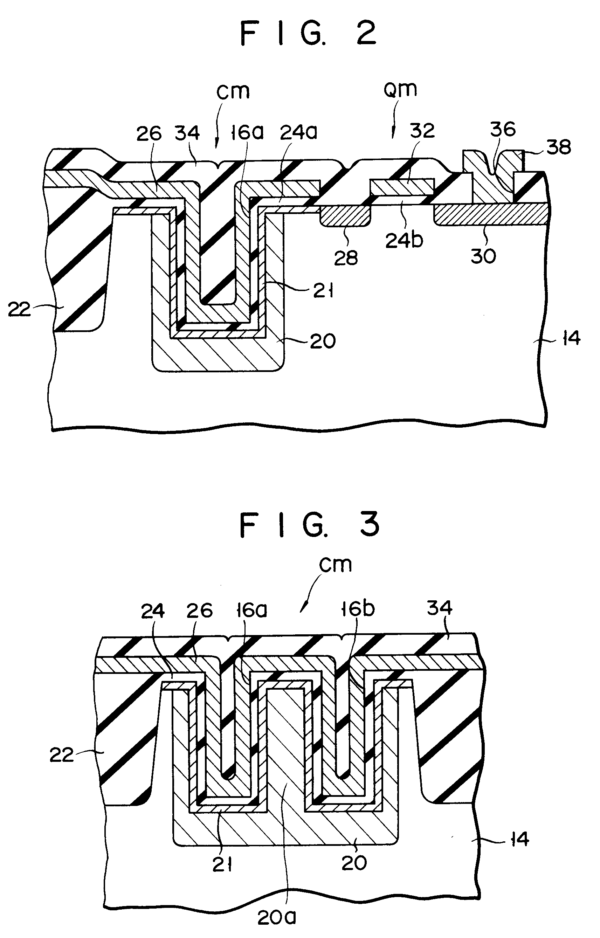

Figs. 2 and 3 are cross sectional views taken along line II-II and line III-III in Fig. 1 and illustrate the memory cell section 10. A p type well region 20 and a semiconductor layer 21 of a second conductivity type or n type, are formed in a cell region defined by a field insulating film 22 formed in the p type substrate 10. The n⁻type semiconductor layer 21 constitutes one of the electrodes of the memory cell capacitor Cm. The two recesses 16a and 16b are formed in the p type well region 20. The way, in which the two recesses 16a and 16b are formed side by side in the well region 20, is most clearly shown in Fig. 3. The recesses 16a and 16b are formed by a reactive ion etching (RIE) process using an etching mask (not shown). The p type well region 20 is formed by ion implantation or thermal diffusion of p type impurities. Particularly, the region 20 is formed such that it has a higher impurity concentration than the impurity concentration of the p type substrate (and will hereinafter be referred to as $p^+$ type well region). The shape of the $p^+$ type well region 20 is controlled such that it will not intrude into a certain substrate region where a cell transistor Qm to be described later is formed, that is, it will exclude the transistor formation region of the substrate, as is apparent from Fig. 2.

In the MOS capacitor Cm, a gate oxide film 24a and a polycrystalline silicon layer 26, which serves as a capacitor electrode, are formed in the mentioned order on the substrate surface where the recesses 16a and 16b are formed, whereby the MOS capacitor Cm of the memory cell 10 is completed. Attention should be given to the fact that the MOS capacitor electrode 26 is provided commonly over a region other than the MOS FET regions of each memory cell and dummy cell.

As shown in Fig. 2, the MOS FET Qm of the memory cell 10 includes $n^+$ type diffusion layers 28 and 30, which are formed by the ion implantation technique and serve as the source and drain, respectively, and a gate layer 32 formed on the gate oxide film 24b formed on the substrate 14. The gate layer 32 is formed in self-alignment to the $n^+$ type diffusion layers 28 and 30. An insulating layer 34, such as a $SiO_2$ layer for instance, is deposited on the wafer structure described above. A portion of the $SiO_2$ layer 34 on the $n^+$ type layer 30 is removed by a well-known technique, so that an opening is formed as a contact hole 36.

A conductive layer 38 is formed such that it is electrically connected to the drain layer 30 of the MOS FET Qm in the portion thereof exposed in the contact hole 32. The conductive layer 38 serves as a bit line for the MOS FET Qm of the memory cell 10.

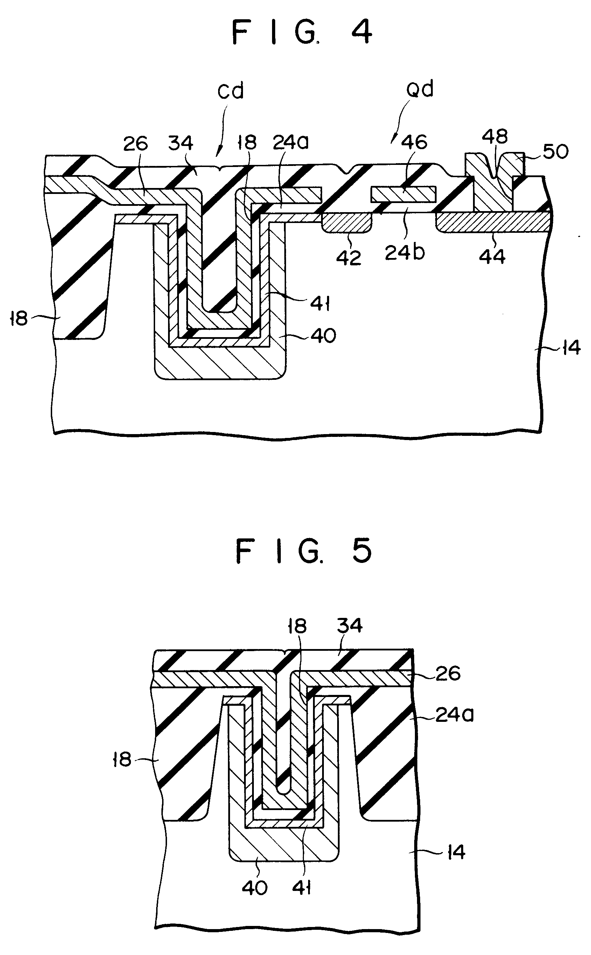

Figs. 4 and 5 are cross sectional views taken along line IV-IV and line V-V in Fig. 1 and illustrate the dummy cell section 12. A $p^+$ type well region 40 and an n type semiconductor layer 41 are formed in a dummy cell region defined by the field insulative film 22 formed in the p type substrate 10. The n type semiconductor layer 41 constitutes one of the electrodes of the dummy cell capacitor Cd. The recess 18 of the dummy cell capacitor Cd, noted above, is formed in the $p^+$ type well region 40. The recess 18 and $p^+$ type well region 40 are formed in the same way as the memory cell 10 described above. A gate oxide film 24a and a polycrystalline silicon layer 26 which serves as a capacitor electrode are formed in the mentioned order on the substrate surface where the recess 18 is formed, thus completing the MOS capacitor Cd of the dummy cell 12.

As shown in Fig. 4, the MOS FET Qd of the dummy cell 12 includes $n^+$ type diffusion layers 42 and 44 serving as the source and drain, respectively, and a gate layer 46, which is formed on the gate oxide film 24b formed on the substrate 14 in a self-aligned relationship with the $n^+$ type diffusion layers 42 and 44. The insulative layer 34, such as a $SiO_2$ layer, that is deposited on the wafer structure noted above is also partly etched away to form a contact hole 48. A conductive layer 50, which, serves as a bit line for the MOS FET Qd of the dummy cell 12, is electrically connected to the drain layer 44 of the MOS FET Qd in the portion thereof exposed in the contact hole 48.

As has been described, the above embodiment of the dRAM according to the invention has two recesses 16a and 16b formed in the MOS capacitor region of the memory cell 10 and one recess 18 formed in the MOS capacitor region of the dummy cell 12. The formation of these recesses 16a, 16b and 18 is necessary for setting the charge storage ratio of the memory cell 10 to the dummy cell 12 to 2 : 1 as is well known to persons skilled in the art. With this embodiment of the invention the capacitance ratio of the memory cell 10 to the dummy cell 12 is set to 2 : 1 with the two recesses provided for the memory cell capacitor and one recess for the dummy cell capacitor, so that an equal constant voltage may be applied as a read-out voltage to both the cells in the data read-out mode. That is, only a single level of voltage is necessary for the data read-out. It is thus possible to simplify the circuit construction necessary for the voltage generation and at the same time stabilize the data read-out operation. The structure with the recesses noted above further greatly contributes to effectively increasing the capacitance without increasing the capacitor surface region area. It is thus possible to greatly increase the amount of charge carriers that can be stored in each capacitor without reducing the memory integration degree.

It should be noted that in the memory cell section of the above structure the impurity concentration of the substrate region surrounding the recesses 16a and 16b is particularly increased. In this embodiment it is important that the two recesses 16a and 16b are confined together with the electrode layer 21 in the $p^+$ type well region 20. The well region 20 has the effect of suppressing or preventing the spread of the depletion layers formed around the recesses 16a and 16b with storage of charge in the cell capacitor Cd when data is stored in the cell. That is, the well region 20 can reliably prevent the depletion layers around the capacitor recesses 16a and 16b from spreading and becoming contiguous to each other in a region 20a between the two recesses 16a and 16b as shown in Fig. 3. Thus, it is possible to improve the charge stored in the capacitor recesses 16a and 16b based on the writing of data in the memory cell 10. This is so because the suppression of the spread of the depletion layers around the recesses 16a and 16b owing to the increased impurity concentration of the well region 20 can improve the charge storage efficiency of the memory cell capacitor Cm that is constituted by the recesses 16a and 16b. Further, the suppression of the spread of the depletion layers around the recesses 16a and 16b permits satisfactory setting of the capacitance ratio of the memory cell to the dummy cell to 2 : 1. This permits an improvement of the basic electric performance of the dRAM.

According to the invention, it is further possible to suppress the fluctuations or errors in the etching process of forming the recesses 16a, 16b and 18 in the substrate 14 basically to zero very readily and without need of any special etching technique. This means that the following advantages can be obtained:

(1) The capacitance ratio between the memory cell 10 and dummy cell 12 can be controlled with high precision or improved precision.
(2) The normal operation redundancy of the sense amplifier circuit that is required for the data read-out can be improved to improve the reliability of the data read-out operation.

This is so because the memory capacitor Cm is not formed of a single enlarged recess but of two recesses 16a and 16b of an identical rectangular planar shape, which is the same in shape and total length as the four sides of the recess 18 formed in the dummy cell 12. The reason for this is that the formation of the two recesses 16a and 16b in the memory cell capacitor section can equalize the rate of increase of capacitance of the dummy cell due to an error in the etching process and the rate of increase of the capacitance of the memory cell due to an error in the etching process.

Detailed elucidation will now be made of the fact that the structure of the embodiment where the ratio of the number of recesses between the memory cell and dummy cell is 2 : 1 which permits precise setting of the capacitance ratio between the memory cell capacitor and dummy cell capacitor to 2 : 1 even if errors occur in the etching process. Denoting the total length of the four sides of the recess 18 provided in the MOS capacitor section of the dummy cell 12 by Ld, the sum Lm of the total lengths of the four sides of the two recesses 16a and 16b provided in the MOS capacitor section of the memory cell 10 is Lm = 2Ld. Now it is assumed that an error $\Delta L$ occurs in the X- and Y-directions of the substrate surface in the etching process of recess formation in the substrate 14 of the dRAM. In this case, the total length Ld of the four sides of the recess 18 of the dummy cell capacitor Cd is increased to Ld + $4\Delta L$, and the rate of increase is $4\Delta L/Ld$. The dummy cell capacitance is also increased at this rate. On the other hand, the sum Lm of the total lengths of the four sides of the recesses 16a and 16b of the memory cell capacitor Cm is increased to Lm + $2(4\Delta L)$, and the rate of increase is $8\Delta L/Lm$. Since Lm = 2Ld,

$$8\Delta L/Lm = 8\Delta L/2Ld = 4\Delta L/Ld.$$

Hence, the rate of increase of the sum Lm of the total lengths of the four sides of the recesses 16a and 16b of the memory cell capacitor Cm is equal to the rate of increase of the total length of the four sides of the recess 18 of the dummy cell capacitor Cd. That is, if an error is produced in the recesses 16a, 16b and 18 in the etching process, the rate of capacitance increases (not the capacitor increase) due to the error being equal for the memory cell 10 and for the dummy cell 12. In other words, when the total length Ld of the four sides of the recess 18 of the dummy cell capacitor Cd is increased, the aggregate side length of the recesses 16a and 16b of the MOS capacitor Cm of the memory cell 10 is also increased at double the rate of increase of the total side length of the dummy cell capacitor recess. In effect, the capacitance ratio substantially remains unchanged.

In contrast, where only a single large recess is provided for the memory cell 20 such that the total length of its four sides is double that of the recess 18 of the dummy cell section 12, if the capacitance of the dummy cell 12 is increased with an increase of the total length Ld of the source sides of the recess 18 due to an error $\Delta L$ in the etching process for the formation of recesses in the substrate surface, the capacitance of the memory cell 10 will increase at a different rate from the rate of increase of the capacitance of the dummy cell 12 (i.e., at a greater rate). Therefore, the capacitance ratio between the memory cell and dummy cell will be greatly deviated from the normal ratio. In this case, therefore, precise setting of the capacitance ratio can no longer be expected with the existing fabrication technology level. Approaches to solve the problem by improving the etching technology itself would dictate an enormous development cost to the enterprise. Besides, it would take a considerable time until such an improvement is in practical use.

While in the above embodiment the high impurity density well region has been formed to surround the two recesses 16a and 16b formed in the memory cell 10, such a well region is by no means limitative. In a case where it is difficult to diffuse impurities in the regions corresponding to the two recesses 16a and 16b in each memory cell due to a fabrication process ground, a high impurity concentration region may be formed over the entire area inclusive of the cell transistor formation region, and then the transistor formation region may be set substantially to the same impurity density as that of the substrate. It is important that a high impurity concentration region be formed only in a cell capacitor region so that it will not extend into the cell transistor formation region. So long as this is satisfied, it is possible to suppress or prevent an undesired spread of the depletion layers around the two recesses 16a and 16b of each memory cell, which is a basic feature of the invention.

## Claims

1.  A semiconductor memory device comprising a plurality of memory cells (10) formed on a semiconductive substrate (14), in which each memory cell comprises:

    a memory cell transistor (Qm) and a memory cell capacitor (Cm), each capacitor (Cm) comprises recess means (16a, 16b) formed in said substrate and each capacitor (Cm) is charged so as to reflect the logic state of its memory cell (10);

    depletion layer spread suppressing means (20) for suppressing the spread of depletion layers formed around said recess means (16a, 16b) of said memory cell capacitor (Cm) when charge is stored therein, thereby improving the charge storage efficiency of said memory cell capacitor; and

    a plurality of dummy cells (12) each having a dummy cell transistor (Qd) and a dummy cell capacitor (Cd) having recess means, said capacitor being adapted to be precharged to a selected voltage level,

    characterised in that said recess means comprises two first recesses (16a, 16b) whereas said recess means of said dummy cell capacitor (Cd) has one further recess (18), said first and further recesses being substantially equal in size such that a capacitance ratio of 2:1 between said memory cell capacitor (Cm) and said dummy cell capacitor (Cd) is controlled with an improved accuracy.

2.  The device according to claim 1, characterised in that said depletion layer spread suppressing means comprises a semiconductive region (20) surrounding said two first recesses of said memory cell capacitor, excluding said memory cell transistor and having the same conductivity type as the conductivity type of said substrate, said semiconductive region (20) having a higher impurity concentration than the impurity concentration of said substrate (14).

3.  The device according to claim 2, characterised in that said semiconductive region comprises a well region (20) formed in said substrate (14) such that said two first recesses of said memory cell capacitor are located in said well region (20).

4.  The device according to claim 3, characterised in that the sum of the lengths of the peripheries of said two recesses (16a, 16b) of each said memory cell capacitor is double the length of the periphery of said recess (18) of each said dummy cell capacitor, whereby, in an etching process for forming said first recesses (16a, 16b) and said further recess (18) which respectively determine the memory cell capacitance and the dummy cell capacitance, even if the planar shapes are changed due to an etching fabrication error, the peripheral length ratio of the first recesses (16a, 16b) to the further recess (18) after the processing is constant so that the capacitance ratio of said first recesses (16a, 16b) to said further recess (18) coincides with a predetermined value.

5.  The device according to claim 4, characterised in that said first recesses (16a, 16b) and further recess (18) are formed simultaneously on said substrate by the same etching process such that they have an equal depth.

6.  The device according to claim 5, characterised in that each of said first recess (16a, 16b) has the same planar shape as the planar shape of said further recess (18).

7.  The device according to claim 6, characterised in that said first recesses (16a, 16b) and further recess (18) have a rectangular planar shape.

## Revendications

1.  Un dispositif de mémoire semiconductrice comprenant une pluralité de cellules de mémoire (10), formées sur un substrat semiconducteur (14), dans lequel chaque cellule de mémoire comprend:

    un transistor à cellule de mémoire (Qm) et un condensateur à cellule de mémoire (Cm), chaque condensateur (Cm) comprenant des moyens enfoncés (16a, 16b), formés dans ledit substrat et chaque condensateur (Cm) étant chargé de façon à refléter l'état logique de sa cellule de mémoire (10);

un moyen de suppression de la croissance de couches d'appauvrissement (20), formées autour des dits moyens enfoncés (16a, 16b) du dit condensateur à cellule de mémoire (Cm) en cas de stockage d'une charge dans celle-ci, améliorant ainsi l'efficacité de la mémoire capacitive du dit condensateur à cellule de mémoire; et

plusieurs cellules factices (12) ayant chacune un transistor à cellule factice (Qd) et un condensateur à cellule factice (Cd), comportant des moyens enfoncés, ledit condensateur étant adapté pour être préchargé à un niveau de tension sélectionné,

caractérisé en ce que ledit moyen enfoncé comprend deux premiers enfoncements (16a, 16b), ledit moyen enfoncé du dit condensateur à cellule factice (Cd) comportant un enfoncement supplémentaire (18), lesdits premiers enfoncements et ledit enfoncement supplémentaire ayant des dimensions à peu près égales, de sorte qu'un rapport de capacité de 2:1 entre ledit condensateur à cellule de mémoire (Cm) et ledit condensateur à cellule factice (Cd) est réglé avec une précision accrue.

2.  Le dispositif selon la revendication 1, caractérisé en ce que ledit moyen de suppression de la croissance de la couche d'appauvrissement comprend une région semiconductrice (20) entourant lesdits deux premiers enfoncements du dit condensateur à cellule de mémoire, excluant ledit transistor à cellule de mémoire et ayant le même type de conductivité que le type de conductivité du dit substrat, ladite région semiconductrice (20) ayant une concentration en impuretés plus élevée que la concentration en impuretés du dit substrat (14).

3.  Le dispositif selon la revendication 2, caractérisé en ce que ladite région semiconductrice comprend une région abaissée (20) formée dans ledit substrat (14), de sorte que lesdits deux premiers enfoncements du dit condensateur à cellule mémoire sont situés dans ladite région abaissée (20).

4.  Le dispositif selon la revendication 3, caractérisé en ce que la somme des longueurs des périphéries des dits deux enfoncements (16a, 16b) de chaque condensateur à cellule mémoire correspond au double de la longueur de la périphérie du dit enfoncement (18) de chacun des dits condensateurs à cellule factice, et en ce que, au cours d'un procédé de gravure pour la formation des dits premiers enfoncements (16a, 16b) et du dit enfoncement supplémentaire (18), déterminant respectivement la capacité de la cellule de mémoire et la capacité de la cellule factice, on aura donc, même en cas d'un changement des formes planes dû à une erreur de gravure, un rapport constant entre la longueur périphérique des premiers enfoncements (16a, 16b) et l'enfoncement supplémentaire (18) après le traitement, le rapport de capacité entre lesdits premiers enfoncements (16a, 16b) et ledit enfoncement supplémentaire (18) correspondant à une valeur prédéfinie.

5.  Le dispositif selon la revendication 4, caractérisé en ce que lesdits premiers enfoncements (16a, 16b) et l'enfoncement supplémentaire (18) sont formés simultanément sur ledit substrat par le même procédé de gravure, de sorte qu'ils ont la même profondeur.

6.  Le dispositif selon la revendication 5, caractérisé en ce que chacun desdits premiers enfoncements (16a, 16b) a la même forme plane que la forme plane du dit enfoncement supplémentaire (18).

7.  Le dispositif selon la revendication 6, caractérisé en ce que lesdits premiers enfoncements (16a, 16b) et ledit enfoncement supplémentaire (18) ont une forme rectangulaire plane.

**Patentansprüche**

1.  Halbleiterspeicheranordnung mit einer Vielzahl von auf bzw. in einem Halbleitersubstrat (14) ausgebildeten Speicherzellen (10), wobei jede Speicherzelle umfaßt: einen Speicherzellentransistor (Qm) und einen Speicherzellenkondensator (Cm), wobei jeder Kondensator (Cm) im Substrat ausgebildete Vertiefungsmittel (16a, 16b) aufweist und jeder Kondensator (Cm) so aufladbar ist, daß er den logischen Zustand seiner (zugeordneten) Speicherzelle (10) widerspiegelt, eine Verarmungsschichtausbreitung-Unterdrückungseinheit (20) zum Unterdrücken der Ausbreitung von Verarmungsschichten, die um die Vertiefungsmittel (16a, 16b) des Speicherzellenkondensators (Cm) herum entstehen, wenn in diesem Ladung gespeichert ist, um damit den Ladungsspeicherwirkungsgrad des Speicherzellenkondensators zu verbessern, und eine Vielzahl von Blindzellen (12), die jeweils einen Blindzellentransistor (Qd) und einen Blindzellenkondensator (Cd) mit Vertiefungsmitteln aufweisen, wobei der Kondensator auf einen gewählten Spannungspegel voraufladbar ist,

dadurch gekennzeichnet, daß die Vertiefungsmittel zwei erste Vertiefungen oder Ausnehmungen (16a, 16b) umfassen, während die Vertiefungsmittel des Blindzellenkondensators (Cd) eine weitere Vertiefung oder Ausnehmung (18) aufweisen, wobei die ersten Vertiefungen und die weitere Vertiefung im wesentlichen gleiche Größe besitzen, so daß ein Kapazitätsverhältnis von 2:1 zwischen dem Speicherzellenkondensator (Cm) und dem Blindzellenkondensator (Cd) mit verbesserter Genauigkeit steuerbar bzw. einstellbar ist.

2. Anordnung nach Anspruch 1, dadurch gekennzeichnet, daß die Verarmungsschichtausbreitung-Unterdrückungseinheit eine die beiden ersten Vertiefungen des Speicherzellenkondensators unter Ausschuß des Speicherzellentransistors umgebende Halbleiterzone (20) des gleichen Leitungstyps wie das Substrat umfaßt und die Halbleiterzone (20) eine höhere Fremdatomkonzentration als das Substrat (14) aufweist.

3. Anordnung nach Anspruch 2, dadurch gekennzeichnet, daß die Halbleiterzone eine im Substrat (14) in der Weise ausgebildete Wannenzone (20) umfaßt, daß die beiden ersten Vertiefungen des Speicherzellenkondensators innerhalb der Wannenzone (20) liegen.

4. Anordnung nach Anspruch 3, dadurch gekennzeichnet, daß die Summe der Längen der Umfänge der beiden Vertiefungen (16a, 16b) jedes Speicherzellenkondensators das Doppelte der Umfangslänge der Vertiefung (18) des Blindzellenkondensators beträgt, so daß in einem Ätzprozeß zur Ausbildung der ersten Vertiefungen (16a, 16b) und der weiteren Vertiefung (18), die jeweils die Speicherzellenkapazität bzw. die Blindzellenkapazität bestimmen, auch dann, wenn sich die planaren Formen aufgrund von Ätzfertigungsfehlern ändern, das Umfangslängenverhältnis der ersten Vertiefungen (16a, 16b) zur weiteren Vertiefung (18) nach der Bearbeitung konstant ist, so daß das Kapazitätsverhältnis der ersten Vertiefungen (16a, 16b) zur weiteren Vertiefung (18) mit einer vorbestimmten Größe übereinstimmt.

5. Anordnung nach Anspruch 4, dadurch gekennzeichnet, daß die ersten Vertiefungen (16a, 16b) und die weitere Vertiefung (18) mittels des gleichen Ätzprozesses gleichzeitig am bzw. im Substrat ausgebildet werden, so daß sie jeweils gleiche Tiefe aufweisen.

6. Anordnung nach Anspruch 5, dadurch gekennzeichnet, daß jede der ersten Vertiefungen (16a, 16b) die gleiche planare Form wie die planare Form der weiteren Vertiefung (18) aufweist.

7. Anordnung nach Anspruch 6, dadurch gekennzeichnet, daß die ersten Vertiefungen (16a, 16b) und die weitere Vertiefung (18) jeweils eine rechteckige planare Form aufweisen.

# F I G. 1

# F I G. 2

# F I G. 3

# F I G. 4

# F I G. 5